Europäisches Patentamt

**European Patent Office**

**Office européen des brevets**

(11) Numéro de publication: **0 274 318 B1**

(12) **FASCICULE DE BREVET EUROPEEN**

(45) Date de publication de fascicule du brevet: **08.04.92**   (51) Int. Cl.⁵: **C08F 20/10**, C09D 133/08

(21) Numéro de dépôt: **87402893.9**

(22) Date de dépôt: **17.12.87**

Le dossier contient des informations techniques présentées postérieurement au dépôt de la demande et ne figurant pas dans le présent fascicule.

(54) **Procédé de polymérisation anionique de monomères acryliques et éventuellemet de comonomères vinyliques.**

(30) Priorité: **19.12.86 FR 8617790**

(43) Date de publication de la demande:
**13.07.88 Bulletin 88/28**

(45) Mention de la délivrance du brevet:
**08.04.92 Bulletin 92/15**

(84) Etats contractants désignés:
**AT BE CH DE ES FR GB GR IT LI LU NL SE**

(56) Documents cités:
EP-A- 0 185 641
DE-B- 1 179 376
FR-A- 2 201 304
FR-A- 2 398 079
US-A- 3 687 978

CHEMICAL ABSTRACTS, vol. 103, no. 18, novembre 1985, page 10, résumé no. 142525u, Columbus, Ohio, US; & JP-A-60 67 504 (DAICEL CHEMICAL INDUSTRIES LTD) 17-04-1985

(73) Titulaire: **ATOCHEM**
**4 & 8, Cours Michelet La Défense 10**
**F-92800 Puteaux(FR)**

(72) Inventeur: **Teyssie, Philippe**
**Avenue du Bois Impérial du Rognac, 85**
**B-4121 Neuville-en-Condroz(BE)**
Inventeur: **Varshney, Sunil Kumar**
**Rue de la Croix Rouge, 9/134**
**B-4020 Liège(BE)**
Inventeur: **Jérome, Robert**
**Rue des Sorbiers, 6**
**B-4040 Tilff(BE)**
Inventeur: **Fayt, Roger**
**Route du Condroz, 144**
**B-4121 Neupre Neuville(BE)**

(74) Mandataire: **Rochet, Michel et al**
**ATOCHEM Département Propriété Industriel-le 4, Cours Michelet La Défense 10 Cedex 42**
**F-92091 Paris-La-Défense(FR)**

Rank Xerox (UK) Business Services

## Description

La présente invention est relative à un procédé de polymérisation de monomères acryliques et éventuellement de comonomères vinyliques à l'aide d'un amorceur de formule

R - M   (1)

dans laquelle M désigne un métal choisi parmi les métaux alcalins et alcalino-terreux et R désigne un radical alkyle à chaîne droite ou ramifiée contenant 2 à 6 atomes de carbone ou un radical aryle.

On connaît des procédés de polymérisation de monomères acryliques ou méthacryliques, tels que des acrylates et méthacrylates d'alkyle, ainsi que des procédés de copolymérisation de tels monomères acryliques ou méthacryliques ainsi que de co-monomère vinyliques, en présence de divers agents amorceurs notamment ceux de formule (1) donnée plus haut, comme par exemple le sec.-butyllithium, le naphtalène sodium, le 1,4 disodio-1,1,4,4 tétraphénylbutane, le diphénylméthylpotassium, le diphénylméthylsodium, 1′ -méthylstyryllithium, le 1,1-diphényl-3-méthylpentyllithium et d'autres, comme les alcoolates tertiaires de lithium et des composés contentant des groupes triméthylsilyle.

Il est également connu d'utiliser dans les réactions de polymérisation de monomères acryliques et éventuellement de co-monomères non acryliques, des additifs ou des catalyseurs divers, notamment des co-catalyseurs ou additifs contenant par exemple des sources d'ions fluorure, cyanure ou acide ou constitués par un acide de Lewis. Enfin il est connu par la demande de brevet EP-A 0.185.641 d'utiliser comme additif un sel alcalin ou alcalino-terreux d'acide minéral.

D'autre part le brevet français n° 2.201.304 décrit la polymérisation de monomères vinyliques, en particulier les acrylates et méthacrylates d'alkyle ou de cycloalkyle, par des amorceurs anioniques, en milieu solvant organique et en présence d'un agent complexant macrohétérocyclique azoté en quantité au moins équimolaire par rapport à l'amorceur anionique. Plus précisement, ce document décrit la polymérisation du méthacrylate de méthyle, à -78°C et +25°C, dans le benzène ou le tétrahydrofuranne. Le certificat d'addition français n° 2.398.079, rattaché au brevet précédent, décrit une variante de polymèrisation en l'absence de solvant; dans le cas du méthacrylate de méthyle, la polymérisation effectuée à -40°C, et respectivement -80°C, conduit à des polymères de masse moléculaire moyenne en nombre 150.000 et, respectivement 400.000.

On a découvert à présent qu'il est avantageux d'effectuer la polymérisation de monomères acryliques ou méthacryliques, le cas échéant avec des co-monomères vinyliques, à l'aide d'un amorceur de formule (1) donnée plus haut, et en présence d'au moins un additif constitué d'un complexant macrocyclique non azoté.

L'utilisation d'un complexant macrocyclique non azoté en plus de l'agent amorceur de formule R-M définie plus haut offre, ainsi qu'on a pu le constater, de remarquables avantages. Ainsi, elle permet d'obtenir une distribution plus étroite des masses des polymères et copolymères et de préparer des polymères ayant des structures et des masses prédéterminées.

L'emploi d'un complexant macrocyclique non azoté dans le procédé suivant l'invention permet de régler la réactivité de l'agent amorceur. Il diminue avantageusement la réactivité de cet agent amorceur et le rend sélectif vis-à-vis de la double liaison du monomère acrylique ou méthacrylique plutôt que vis-à-vis du groupe ester de ce monomère.

Comme exemples de complexants macrocycliques non azotés utilisables comme additifs dans le cadre de la présente invention, on peut citer en particulier des polyethers cycliques (encore dénomés éthers-couronne) et des polythioéthers cycliques, tels que notamment des polyethers macrocycliques dont l'anneau macrocyclique contient au moins 14 atomes de carbone et d'oxygène, chaque atom d'oxygène de l'anneau étant séparé des autres atomes d'oxygène de l'anneau par deux ou bien trois atomes de carbone ; de tels polyethers macrocycliques ont déjà été décrits dans le brevet US-A-3.687.978.

Des exemples plus précis sont notamment :
- le 1,4,7,10,13,16-hexaoxacyclooctadécane,
- le 2,3,11,12-dibenzo-1,4,7,10,13,16-hexaoxacyclooctadéca-1,11-diène,
- le 2,3,12,13-dibenzo-1,4,11,14-tétraoxacycloeicosa-2,12-diène,
- le 2,3,12,13,22,23-tribenzo-1,4,11,14,21,24-hexaoxacyclotriaconta-2,12,22-triène,
- le 2,2,7,7,12,12,17,17-octaméthyl-21,22,23,24-tétraoxaquaterene,
- le 2,3-benzo-1,4,7,10,13-pentaoxacyclopentadeca-2-ene,
- le 2,3-(4′-t-butyl)-1,4,7,10,13,16-hexaoxacyclooctadeca-2-ene,
- le 2,3,9,10-dibenzo-1,4,8,11-tetraoxacyclotetradeca-2,9-diene,
- le 2,3,32,33-dibenzo-1,4,7,10,13,16,19,22,25,28,31,34,37,40,43,46,-49,52,55,58 eicosaoxacyclohexaconta-2,32-diene,
- le 2,3,16,17-dibenzo-1,4,15,18-tetraoxacyclooctacosa-2,16-diène,
- le 2,6,13,17-tétraoxatricyclo[16.4.0.0$^{7,12}$]-docosane,
- le 2,5,8,15,18,21-hexaoxatricyclo-

[20.4.0.0$^{9,14}$]hexacosane,

- le 2,5,12,15,18-pentaoxatricyclo[17.4.0.0$^{6,11}$]-tricosane,
- le 2,6,13,16,19-pentaoxatricyclo[18.4.0.0$^{7,12}$]-tetracosane,
- le 9,10-benzo-2,5,8,11,14,17-hexaoxabicyclo-[16.4.0] -docosa-9-ene,
- le 2,3,9,10-dibenzo-1,4,8,11,14,16-hexaoxacyclooctadeca-2,9-diène,
- le 2,3,11,12-dibenzo-1,4,7,10,13,16,18-heptaoxacycloeicosa-2,11-diène,
- le 2,3,13,14-dibenzo-8-pentamethylene-1,4,7,9,12,15,18-heptaoxacylcoeicosa-2,13-diene
- le 2,3,13,14-dibenzo-1,4,7,9,12,15,18,20-octaoxacyclodocosa-2,13diène,
- le 2,4-(1′,8′-naphtylène)-1,5,8,11,14-pentaoxacyclohexadeca-2-ene.

Comme monomères acryliques, on peut utiliser avantageusement, dans le procédé suivant l'invention, des esters des acides acrylique et méthacrylique, les dialkyl(méth)acrylamides, l'acrylonitrile, le méthacrylonitrile et leurs mélanges.

Le monomère acrylique est, de préférence :
- un méthacrylate d'alkyle, dont le radical alkyle, le cas échéant substitué, contient 1 à 18 atomes de carbone, plus particulièrement le méthacrylate de méthyle, le méthacrylate de 2,2,2-trifluoroéthyle, le méthacrylate de butyle.
- un acrylate d'alkyle secondaire ou tertiaire dont le groupe alkyle, le cas échéant substitué, contient de 3 à 8 atomes de carbone, plus particulièrement l'acrylate d'isobutyle, l'acrylate de tertiobutyle, l'acrylate de 2-éthylhexyle.

Comme co-monomère non acrylique, on utilise avantageusement, dans le procédé suivant l'invention, un co-monomère vinylique tel que par exemple le butadiène, l'isoprène, le styrène, le vinylnaphtalène, la vinyl-2-lpyridine, la vinyl-4-pyridine, l'alphaméthylstyrène et le tertiobutylstyrène.

Dans le procédé suivant l'invention, la proportion de complexant macrocyclique non azoté utilisé peut varier fortement par rapport à l'amorceur. Cette quantité peut être, par exemple, largement excédentaire par rapport à la quantité molaire d'agent amorceur. Cette quantité peut aussi être égale ou inférieure à la quantité molaire d'agent amorceur. De préférence le complexant est dans une proportion molaire, vis-à-vis de l'amorceur, au moins égale à 0,5 et allant jusqu'à 5 environ.

Suivant une variante de réalisation du procédé selon l'invention, la réaction de polymérisation peut être effectuée en présence, en outre, d'un sel d'un métal alcalin ou alcalino-terreux, de préférence un halogénure ou un borure d'un tel métal comme par exemple le tétraphénylborure de sodium ou le chlorure de lithium. Ce sel peut être utilisé dans une proportion molaire allant jusqu'à 2 environ par rapport à l'agent amorceur.

Le procédé suivant l'invention permet la préparation de polymères et de copolymères à extrémités de chaînes fonctionnalisés par au moins un groupe, tel qu'un groupe carboxylique (COOH), ainsi que la formation de copolymères séquéncés.

Dans le procédé suivant l'invention, la polymérisation ou copolymérisation s'effectue en l'absence d'humidité et d'oxygène, et en présence d'au moins un solvant choisi de préférence parmi les solvants aromatiques, tels que benzène et 4 toluène, ou bien le tétrahydrofuranne, le diglyme, le tétraglyme, l'orthoterphényle, le biphényle, la décaline ou encore la tétraline.

Quant à la température de polymérisation ou de copolymérisation, elle peut varier entre -78°C et 0°C environ.

Le procédé selon l'invention permet de préparer toute une gamme d'homopolymères et de copolymères à blocs ayant généralement une masse moléculaire moyenne en nombre comprise entre environ 10.000 et 300.000 et un indice de polydispersité génèralement compris entre 1,1 et 4 environ. Parmi ceux-ci figurent notamment, en tant que polymères nouveaux :
- des polymères comportant au moins une séquence de polyméthacrylate de 2,2,2,-trifluoroéthyle et, le cas échéant, une séquence polymère d'un monomère autre que la méthacrylate de 2,2,2-trifluoroéthyle, ces polymères étant caractérisés par une polydispersité comprise entre 1,1 et 4 environ et par un poids moléculaire moyen en nombre de la séquence de polyméthacrylate de 2,2,2-trifluoroéthyle de préférence compris entre 10.000 et 300.000 environ. De tels polymères sont bien adaptés à une utilisation pour l'obtention de vernis photosensibles pour circuit imprimé. Dans une telle utilisation on prépare une solution, à une concentration comprise entre 4 et 20% en poids environ, du polymère dans un solvant inerte tel qu'une cétone puis on dépose cette solution sur le substrat (silicium par exemple) avant d'évaporer le solvant pour laisser former, sur ledit substrat, un film polymère d'épaisseur par exemple comprise entre 0,2 et 2 microns environ.
- des polymères comprenant au moins une séquence polymère d'acrylate d'alkyle secondaire, le groupe alkyle possèdant de 3 à 10 atomes de carbones, et le cas échéant une séquence polymère d'un monomère autre qu'un acrylate d'alkyle secondaire, ces polymères étant caractérisés par une polydispersité comprise entre 1,1 et 4 environ et par un poids moléculaire moyen en nombre de la séquence de polyacrylate d'alkyle secondaire de préférence compris entre 10.000 et 100.000 environ.

Le procédé suivant l'invention est illustré par les exemples non limitatifs suivants.

## EXEMPLE 1

Dans un ballon préalablement séché et sous atmosphère d'azote, on introduit 0,37 gramme ($0,75.10^{-3}$ mole) de 2,3,11,12-dibenzo-1,4,7,10,13,16, hexaoxacyclooctadéca-1,11-diène commercialisé par la société JANSSEN CHIMICA sous l'apellation "dibenzo-18-crown-6".

On y ajoute 150 ml de tétrahydrofuranne préséché et, sous agitation, au goutte à goutte, du naphtalène sodium en solution 0,2 molaire dans le trétrahydrofuranne, jusqu'à apparition d'une coloration rouge persistante. Lorsque cette coloration est atteinte, on ajoute 7,5 ml de ladite solution de naphtalène sodium ($1,5.10^{-3}$ moles). On porte le mélange à la température de -78°C au moyen d'un mélange d'acétone et de carboglace et, après 1/2 heure, on ajoute, toujours à -78°C, 90 ml d'une solution comprenant 0,057 mole d'acrylate de 2-éthyl hexyle dans le tétrahydrofuranne, préalablement séchée à l'aide de triéthylaluminium (1 ml d'une solution 1M dans du benzène) et distillée.

On arrête la réaction après 5 heures par addition de 5 ml de méthanol, après quoi on chasse le solvant. On obtient le polyacrylate de 2-éthylhexyle avec un (rendement de 76%).

L'analyse du polymère par chromatographie sur gel perméable donne les valeurs suivantes :

Mn (masse moléculaire moyenne en nombre : 10.800
Mw/Mn (indice de polydispersité) : 1,7

Dans le présent exemple, tout comme dans les exemples suivants, le tétrahydrofuranne a été préalablement séché sur sodium/benzophénone.

## EXEMPLE 2

Dans un ballon préalablement séché et sous atmosphère d'azote, on introduit 0,252 gramme (0,0007 mole) de "dibenzo-18-crown-6" ainsi que 29 mg de chlorure de lithium (0,0007 mole). On y ajoute 150 ml de tétrahydrofuranne préseché et, sous agitation, au goutte à goutte, du naphtalène sodium en solution 0,2 molaire dans le tétrahydrofuranne jusqu'à apparition d'une coloration rouge persistante. Lorsque cette coloration est atteinte, on ajoute 3,75 ml de ladite solution de naphtalène sodium (0,00075 mole).

On porte le mélange à la température de -78°C au moyen d'un mélange d'acétone et de carboglace et, après 1/2 heure, on ajoute une solution de tétrahydrofuranne comprenant 5 g d'acrylate de 2-ethylhexyle (0,028 mole), préalablement séchée à l'aide de triéthylaluminium et distillée.

Après avoir maintenu la température à -78°C pendant 3 heures, au cours desquelles la coloration rouge persiste, on élève la température jusqu'à -20°C et le maintient à ce niveau pendant 20 heures (une coloration jaune apparaît). On arrête alors la réaction par addition de 5 ml de méthanol, après quoi on chasse le solvant. On obtient 4,9 g de polymère (rendement : 98%).

L'analyse du polymère par chromatographie sur gel perméable donne les valeurs suivantes :

Mn = 19.500          Mw/Mn = 2,1

## EXEMPLE 3

Dans un ballon préalablement séché et sous atmosphère d'azote, on introduit 0,277 g (0,0008 mole) de "dibenzo-18-crown-6".

On y ajoute 150 ml de tétrahydrofuranne préséché et, sous agitation, au goutte à goutte, du naphtalène sodium en solution 0,2 molaire dans le tétrahydrofuranne, jusqu'à apparition d'une coloration rouge persistante. Lorsque cette coloration est atteinte, on ajoute 4 ml de ladite solution de naphtalène sodium (0,0008 mole). On porte le mélange à la température de -78°C dans un mélange d'acétone et de carboglace et, après 1/2 heure, on ajoute toujours à -78°C, 90 ml d'une solution comprenant 0,046 mole de méthacrylate de 2,2,2-tri-fluoroéthyle dans le tétrahydrofuranne, préalable-ment séchée à l'aide de triéthylaluminium (1 ml d'une solution 1M dans du benzène) et distillée.

On arrête la réaction après 4 heures par addition de 5 ml de méthanol, après quoi on chasse le solvant. On obtient 7 g de polymère (rendement 100%).

L'analyse du polymère par chromatographie sur gel perméable donne les valeurs suivantes :

Mn : 26.000          Mw/Mn : 1,23

## EXEMPLE 4

On reproduit l'expérience de l'exemple 3, à l'exception suivante près : on introduit dans le ballon, préalablement au "dibenzo-18-crown-6", 29 mg de chlorure de lithium (0,0007 mole). Après 4 heures de réaction, on obtient 7 grammes de polyméthacrylate de 2,2,2-trifluoroéthyle (rendement : 100%).

L'analyse du polymère par chromatographie sur gel perméable donne les valeurs suivantes :

Mn = 96.000          Mw/Mn = 1,22

## EXEMPLE 5

Dans un ballon préalablement séché et sous atmosphère d'azote, on introduit 10-$^3$ mole de "dibenzo-18-crown-6". On ajoute 400 ml de tétrahydrofuranne préséché et un chaînon vivant de polyméthacrylate de méthyle amorcé par le diphénylméthyl sodium (ce dernier à raison de 10-$^3$ mole en solution molaire dans le tétrahydrofuranne). On porte le mélange à la température de -78°C, au moyen d'un mélange d'acétone et carboglace, puis on ajoute une solution de 25 g de méthacrylate de 2,2,2-trifluoroéthyle dans le tétrahydrofuranne, préalablement séchée et distillée. On arrête la réaction après 4 heures par addition de méthanol, après quoi on chasse le solvant. On obtient avec un rendement de 100% un copolymère à blocs méthacrylate de méthyle/méthacrylate de 2,2,2-trifluoroéthyle. L'analyse du copolymère par chromatographie sur gel perméable donne les valeurs suivantes :

Mn (total) = 33.000      Mw/Mn = 1,33

Mn (séquence méthacrylate de méthyle) = 4.500

Mn (séquence méthacrylate de 2,2,2-trifluoroéthyle) = 28.500

## EXEMPLE 6

Dans un ballon préalablement séché et sous atmosphère d'azote, on introduit 5.10-$^3$ de "dibenzo-18-crown-6". On ajoute 1 litre de tétrahydrofuranne préséché et 1,2.10-$^3$ mole de diphénylméthyl sodium en solution molaire dans le tétrahydrofuranne. On porte le mélange à la température de -78°C, au moyen d'un mélange d'acétone et carboglace, puis on ajoute une solution de 150 g de méthacrylate de 2,2,2-trifluoroéthyle dans le tétrahydrofuranne, préalablement séchée et distillée. On arrête la réaction après 3 heures par addition de méthanol, après quoi on chasse le solvant. On obtient le polymère avec un rendement de 90%).

L'analyse du polymère par chromatographie sur gel perméable donne les valeurs suivantes :

Mn = 185.000      Mw/Mn = 1,33

Un tel polymère est bien adapté à l'obtention de vernis photosensible pour circuit imprimé.

## EXEMPLE 7

Dans un ballon préalablement séché et sous atmosphère d'azote, on introduit 0,2.10-$^3$ mole de "dibenzo-18-crown-6". On ajoute 120 ml de tétrahydrofuranne préséché et 0,2.10-$^3$ de naphtalène sodium en solution molaire dans le tétrahydrofuranne. On porte le mélange à la température de -78°C, au moyen d'un mélange d'acétone et carboglace, puis on ajoute une solution de 5 g d'acrylate d'isobutyle dans le tétrahydrofuranne, préalablement séchée et distillée. On arrête la réaction après 4 heures par addition de méthanol, après quoi on chasse le solvant. On obtient le polyacrylate d'isobutyle avec un rendement de 90%

L'analyse du polymère par chromatographie sur gel perméable donne les valeurs suivantes :

Mn = 37.000      Mw/Mn = 2,0

## EXEMPLE 8

On reproduit l'expérience de l'exemple 7, à l'exception suivante près : on introduit dans le ballon, préalablement au "dibenzo-18-crown-6", 0,4.10$^{-3}$ mole de tétraphénylborure de sodium. Après 4 heures de réaction, on obtient le polyacrylate d'isobutyle avec rendement de 100%.

L'analyse du polymère par chromatographie sur gel perméable donne les valeurs suivantes :

Mn = 36.000      Mw/Mn = 3,6

## EXEMPLE 9

Dans un ballon préalablement séché et sous atmosphère d'azote, on introduit 10-$^3$ de "dibenzo-18-crown-6". On ajoute 400 ml de tétrahydrofuranne préséché et 0,2.10-$^3$ mole de naphtalène sodium en solution molaire dans le tétrahydrofuranne. On porte le mélange à la température de -78°C, au moyen d'un mélange d'acetone et carboglace, puis on ajoute une solution de 5 g d'acrylate d'isobutyle dans le tétrahydrofuranne, préalablement séchée et distillée. On arrête la réaction après 4 heures par addition de méthanol, après quoi on chasse le solvant. On obtient le polyacrylate d'isobutyle avec un rendement de 81%.

L'analyse du polymère par chromatographie sur gel perméable donne les valeurs suivantes :

Mn = 23.000      Mw/Mn = 1,5

## EXEMPLE 10

Dans un ballon préalablement séché et sous atmosphère d'azote, on introduit 0,2.10-$^3$ mole de chlorure de lithium et 0,4.10-$^3$ mole de "dibenzo-18-crown-6". On ajoute 100 ml de tétrahydrofuranne préséché et 0,2.10-$^3$ mole de naphtalène sodium en solution molaire dans le tétrahydrofuranne. On porte le mélange à la température de -78°C, au moyen d'un mélange d'acétone et carboglace, puis on ajoute une solution de 5 g de méthacrylonitrile dans le tétrahydrofuranne, préalablement séchée et distillée. On arrête la réaction après 1 heure par addition de méthanol, après quoi on chasse le solvant. On obtient le polymère avec un rendement de 62%.

## Revendications

**1.** Procédé de polymérisation de monomères acryliques ou méthacryliques à l'aide d'un amorceur de formule

R-M    (I)

dans laquelle M désigne un métal choisi parmi les métaux alcalins et alcalinoterreux et R désigne un radical alkyle à chaîne droite ou ramifiée contenant 2 à 6 atomes de carbone ou un radical aryle, caractérisé en ce qu'on effectue la polymérisation ou copolymérisation en présence d'au moins un complexant macrocyclique non azoté.

2. Procédé selon la revendication 1, caractérisé en ce que le monomère est un acrylate d'alkyle secondaire ou tertiaire dont le groupe alkyle comprend 3 à 8 atomes de carbone.

3. Procédé selon la revendication 1, caractérisé en ce que le monomère est un méthacrylate d'alkyle dont le radical alkyle, le cas échéant substitué, contient 1 à 18 atomes de carbone.

4. Procédé selon la revendication 2, caractérisé en ce que le monomère est l'acrylate d'isobutyle.

5. Procédé selon la revendication 3, caractérisé en ce que le monomère est le méthacrylate de 2,2,2-trifluoroéthyle.

6. Procédé selon l'une des revendications 1 à 5, caractérisé en ce que le monomère acrylique ou méthacrylique est copolymèrisé avec un monomère vinylique.

7. Procédé selon la revendication 6, caractérisé en ce que le monomère vinylique est choisi parmi le butadiène, l'isoprène, le styrène, le vinylnapthtalène, la vinyl-2-pyridine, la vinyl-4-pyridine, l'alphaméthylstyrène et le tertiobutylstyrène.

8. Procédé selon l'une des revendications 1 à 7, caractérisé en ce qu'on effectue la polymérisation à une température entre -78°C et 0°C.

9. Procédé selon l'une des revendications 1 à 8, caractérisé en ce que, en outre, on fonctionnalise les extrémités de chaîne du polymère obtenu par un groupe carboxylique.

10. Procédé selon l'une des revendications 1 à 9, caractérisé en ce que la polymérisation est effectuée en présence d'au moins un solvant.

11. Procédé selon l'une des revendications 1 à 10, caractérisé en ce que le complexant macrocyclique non azoté est le 2,3,11,12-dibenzo-1,4,7,10,13,16-hexaoxacyclooctadéca-1,11-diène.

12. Procédé selon l'une des revendications 1 à 11, caractérisé en ce que la polymérisation est effectuée en présence, en outre, d'un sel d'un métal alcalin ou alcalino-terreux.

13. Procédé selon l'une des revendications 1 à 12, caractérisé en ce que la proportion molaire du complexant macrocyclique non azoté, vis-à-vis de l'amorceur, est au moins égale à 0,5 et au plus égale à 5.

14. Polymère comportant au moins une séquence de polyméthacrylate de 2,2,2-trifluoroéthyle et, le cas échéant, une séquence polymère d'un monomère autre que la méthacrylate de 2,2,2-trifluoroéthyle, caractérisé par une polydispersité comprise entre 1,1 et 4 et par un poids moléculaire moyen en nombre de la séquence de polyméthacrylate de 2,2,2-trifluoroéthyle compris entre 10.000 et 300.000.

15. Vernis photosensible pour circuit imprimé comprenant au moins un polymère selon la revendication 14.

16. Polymère comprenant au moins une séquence polymère d'acrylate d'alkyle secondaire, le group alkyle possèdant de 3 à 10 atomes de carbones, et le cas échéant une séquence polymère d'un monomère autre qu'un acrylate d'alkyle secondaire, caractérisé par une polydispersité comprise entre 1,1 et 4 environ et par un poids moléculaire moyen en nombre de la séquence de polyacrylate d'alkyle secondaire compris entre 10.000 et 100.000.

17. Vernis photosensible pour circuit imprimé selon la revendication 15, sous forme d'un film d'épaisseur comprise entre 0,2 et 2 microns.

**Claims**

1. Process for the polymerisation of acrylic or methacrylic monomers with the aid of an initiator of formula

R-M    (I)

in which M denotes a metal chosen from the alkali and alkaline-earth metals and R denotes an alkyl radical with a straight or branched chain containing 2 to 6 carbon atoms or an aryl radical, characterised in that the polymerisation or copolymerisation is performed in the presence of at least one nonnitrogenous macrocyclic complexant.

2. Process according to Claim 1, characterised in that the monomer is a secondary or tertiary alkyl acrylate in which the alkyl group contains 3 to 8 carbon atoms.

3. Process according to Claim 1, characterised in that the monomer is an alkyl methacrylate in which the alkyl radical, substituted if appropriate, contains 1 to 18 carbon atoms.

4. Process according to Claim 2, characterised in that the monomer is isobutyl acrylate.

5. Process according to Claim 3, characterised in that the monomer is 2,2,2-trifluoroethyl methacrylate.

6. Process according to one of Claims 1 to 5, characterised in that the acrylic or methacrylic monomer is copolymerised with a vinyl monomer.

7. Process according to Claim 6, characterised in that the vinyl monomer is chosen from butadiene, isoprene, styrene, vinylnaphthalene, 2-vinylpyridine, 4-vinylpyridine, alpha-methylstyrene and tert-butylstyrene.

8. Process according to one of Claims 1 to 7, characterised in that the polymerisation is performed at a temperature of between -78°C and 0°C.

9. Process according to one of Claims 1 to 8, characterised in that, in addition, the chain ends of the polymer obtained are functionalised with a carboxylic group.

10. Process according to one of Claims 1 to 9, characterised in that the polymerisation is performed in the presence of at least one solvent.

11. Process according to one of Claims 1 to 10, characterised in that the nonnitrogenous macrocyclic complexant is 2,3,11,12-dibenzo-1,4,7,10,13,16-hexaoxacyclooctadeca-1,11-diene.

12. Process according to one of Claims 1 to 11, characterised in that the polymerisation is performed in the additional presence of a salt of an alkali or alkaline-earth metal.

13. Process according to one of Claims 1 to 12, characterised in that the molar proportion of the non-nitrogenous macrocyclic complexant, in relation to the initiator, is at least 0.5 and not more than 5.

14. Polymer containing at least one poly-2,2,2-trifluoroethyl methacrylate block and, if appropriate, a polymeric block of a monomer other than 2,2,2-trifluoroethyl methacrylate, characterised by a polydispersity of between 1.1 and 4 and by a number-average molecular weight of the poly-2,2,2-trifluoroethyl methacrylate block of between 10,000 and 300,000.

15. Photosensitive varnish for a printed circuit comprising at least one polymer according to Claim 14.

16. Polymer comprising at least one secondary alkyl acrylate polymer block, the alkyl group containing from 3 to 10 carbon atoms, and, if appropriate, a polymeric block of a monomer other than a secondary alkyl acrylate, characterized by a polydispersity of approximately between 1.1 and 4 and by a number-average molecular weight of the secondary alkyl polyacrylate block of between 10,000 and 100,000.

17. Photosensitive varnish for a printed circuit according to Claim 15, in the form of a film with a thickness of between 0.2 and 2 microns.

**Patentansprüche**

1. Verfahren zur Polymerisation von Acryl- oder Methacrylmonomeren mit Hilfe eines Initiators der Formel

R-M    (I)

in der M ein Metall, ausgewählt aus Alkali- und Erdalkalimetallen und R einen geradkettigen oder verzweigten Alkylrest mit 2 bis 6 Kohlenstoffatomen oder einen Arylrest bedeuten, dadurch gekennzeichnet, daß man die Polymerisation oder die Copolymerisation in Gegenwart von mindestens einem nicht stickstoffhaltigen makrozyklischen Komplexbildner durchführt.

2. Verfahren nach Anspruch 1, dadurch gekennzeichnet, daß das Monomere ein Alkylacrylat ist, dessen sekundäre oder tertiäre Alkylgruppe 3 bis 8 Kohlenstoffatome enthält.

3. Verfahren nach Anspruch 1, dadurch gekennzeichnet, daß das Monomere ein Alkylmethacrylat ist, dessen gegebenenfalls substituierten Alkylrest 1 bis 18 Kohlenstoffatome enthält.

4. Verfahren nach Anspruch 2, dadurch gekennzeichnet, daß das Monomere Isobutylacrylat ist.

5. Verfahren nach Anspruch 3, dadurch gekennzeichnet, daß das Monomere 2,2,2-Trifluorethylmethacrylat ist.

6. Verfahren nach einem der Ansprüche 1 bis 5, dadurch gekennzeichnet, daß das Acryl- oder Methacrylmonomere mit einem Vinylmonomeren copolymerisiert ist.

7. Verfahren nach Anspruch 6, dadurch gekennzeichnet, daß das Vinylmonomere aus Butadien, Isopren, Styrol, Vinylnaphtalin, 2-Vinylpyridin, 4-Vinyl-pyridin, Alphamethylstyrol und tert-Butylstyrol ausgewählt ist.

8. Verfahren nach einem der Ansprüche 1 bis 7, dadurch gekennzeichnet, daß man die Polymerisation bei einer Temperatur zwischen -78°C und 0°C durchführt.

9. Verfahren nach einem der Ansprüche 1 bis 8, dadurch gekennzeichnet, daß man zusätzlich die Enden der erhaltenen Polymerkette durch eine Carboxylgruppe funktionalisiert.

10. Verfahren nach einem der Ansprüche 1 bis 9, dadurch gekennzeichnet, daß man die Polymerisation in Gegenwart wenigstens eines Lösungsmittels durchführt.

11. Verfahren nach einem der Ansprüche 1 bis 10, dadurch gekennzeichnet, daß der nicht stickstoffhaltige makrozyklische Komplexbildner 2,3,11,12-Dibenzo-1,4,7,10,13,16-hexaoxacyclooctadeca-1,11-dien ist.

12. Verfahren nach einem der Ansprüche 1 bis 11, dadurch gekennzeichnet, daß die Polymerisation außerdem in Gegenwart eines Salzes eines Alkali- oder Erdalkimetalls durchgeführt wird.

13. Verfahren nach einem der Ansprüche 1 bis 12, dadurch gekennzeichnet, daß das Molverhältnis von nicht-stickstoffhaltigem makrozyklischem Komplexbildner zum Initiator mindestens 0,5 und höchstens 5 ist.

14. Polymeres mit wenigstens einer 2,2,2-Trifluorethylpolymethacrylatsequenz und gegebenenfalls einer Polymersequenz eines anderen Monomeren als 2,2,2-Trifluorethylmethacrylat, gekennzeichnet durch eine Polydispersität zwischen 1,1 und 4 und ein mittleres Molekulargewicht der 2,2,2-Trifluorethylpolymethacrylatsequenz zahlenmäßig zwischen 10.000 und 300.000.

15. Fotosensibler Lack für gedruckte Schaltungen, der wenigstens ein Polymeres nach Anspruch 14 enthält.

16. Polymeres, das wenigstens eine Polymersequenz eines sekundären Alkylacrylats, mit 3 bis 10 Kohlenstoffatomen in der Alkylgruppe und gegebenenfalls eine Polymersequenz eines anderen Monomeren als das sekundäre Alkylacrylat enthält, gekennzeichnet durch eine Polydispersität zwischen 1,1 und etwa 4 und ein mittleres Molekulargewicht der sekundären Alkylpolyacrylatsequenz zahlenmäßig zwischen 10.000 und 100.000.

17. Fotosensibler Lack für gedruckte Schaltungen nach Anspruch 15, in Form eines Films einer Dicke zwischen 0,2 und 2 Mikrometer.